# FASCICULE DE BREVET EUROPEEN

(11) **EP 0 466 598 B1**
(45) Date de publication et mention de la délivrance du brevet: **11.01.1995**
(21) Numéro de dépôt: 91401941.9
(22) Date de dépôt: 11.07.1991
(51) Int. Cl.: G02B 1/10, H01S 3/025, C23C 14/54

(54) **Procédé et installation de dépôt de couches antireflet et de contrôle de leur épaisseur**
Verfahren und Einrichtung zur Ablagerung von Antireflektionsschichten und zur Kontrolle ihrer Dicke
Method and apparatus for deposition of antireflection coatings and control of their thickness

(30) Priorité: 13.07.1990 FR 9008947
(43) Date de publication de la demande: 15.01.1992
(73) Titulaire: FRANCE TELECOM, 92131 Issy les Moulineaux (FR)
(72) Inventeur: Landreau, Jean, F-92160 Antony (FR); Nakajima, Hisao, F-75014 Paris (FR)
(74) Mandataire: Signore, Robert

(56) Documents cités:
- US-A- 3 846 165
- APPLIED OPTICS. vol. 27, no. 8, 15 Avril 1988, NEW YORK US pages 1391 - 1393;S. SOMANI ET AL.: 'Real-time monitoring of laser diode facet reflectivity whilebeing coated with SiOx '
- APPLIED OPTICS. vol. 26, no. 5, 1 Mars 1987, NEW YORK US pages 845 - 849; M.SERENYI ET AL.: 'Directly controlled deposition of antireflection coatings for semiconductor lasers '
- IBM TECHNICAL DISCLOSURE BULLETIN. vol. 27, no. 8, Janvier 1985, NEW YORK US pages 4667 - 4668; S.S. BHATTACHARYA ET AL.: 'Multiple automatic retractable distribution shields '

## Description

La présente invention a pour objet un procédé et une installation de dépôt de couches antireflet et de contrôle de leur épaisseur.

Elle trouve une application dans la réalisation d'amplificateurs lasers à semi-conducteurs de type non résonnant, utilisables en télécommunications optiques.

On sait qu'une couche antireflet est une couche transparente dont l'indice n satisfait à la relation n²=n₀ où n₀ est l'indice du substrat sur lequel elle est déposée et dont l'épaisseur e est égale à λ/4n où λ est la longueur d'onde du rayonnement pour lequel on veut supprimer le reflet.

Pour un matériau donné, l'épaisseur de la couche doit être ajustée soigneusement. Il est admis qu'une "bonne" couche antireflet est une couche dont la réflectivité est inférieure à 10⁻³. Cette valeur très faible impose des contraintes sévères sur l'épaisseur, qui doit être ajustée à mieux que 10⁻².

L'obtention de bonnes couches antireflet est donc relativement difficile.

On connaît des procédés de contrôle de l'épaisseur de telles couches lorsque celles-ci sont déposées sur les faces latérales d'une structure laser à semi-conducteurs :
- l'article intitulé "Real-time monitoring of laser diode facet reflectivity while being coated with SiOₓ", publié par A. SOMANI et al. dans la revue "Applied Optics", vol. 27, n° 8, avril 1988, pp. 1391-1393, décrit un procédé dans lequel on mesure l'intensité lumineuse émise par la diode laser en fonction du temps ; lorsque cette intensité passe par un minimum, la réflectivité passe elle aussi par un minimum et le processus de dépôt est interrompu ;
- le brevet américain US-A-3 846 165 décrit un procédé dans lequel on mesure l'intensité du rayonnement émis par le laser, laquelle est une fonction de la réflectivité de la couche déposée ; lorsque la puissance mesurée correspond à la réflectivité désirée, le processus de dépôt est interrompu ;
- l'article de M. SERENYI et al., intitulé "Directly controlled deposition of anti-reflection coatings for semiconductor laser", publié dans la revue "Applied Optics", Mars 1, 1987, vol. 26, n° 5, pp. 845-849, décrit encore un procédé dans lequel on alimente la structure semi-conductrice en courant et on mesure l'intensité lumineuse spontanée émise à travers la couche en cours de dépôt ; on recherche alors un maximum de puissance lumineuse.

Toutes ces technique présentent de nombreux inconvénients. Tout d'abord, le photorécepteur qu'elles nécessitent doit être placé de manière à recueillir un maximum de lumière ; or, cette exigence est difficilement compatible avec la nécessité de ne pas masquer la face à traiter. Ensuite, ce même photorécepteur étant sensible à la lumière émise dans l'enceinte de dépôt (par le canon d'évaporation ou le plasma), il faut masquer cette lumière parasite et utiliser pour cela des filtres interférométriques, lesquels réduisent l'intensité lumineuse à mesurer ; cet affaiblissement est d'autant plus gênant qu'à son minimum, l'intensité à mesurer est déjà très faible. Enfin, un alignement rigoureux doit être réalisé entre le laser et le photorécepteur, et cela à l'aide de lentilles, miroirs, fibres optiques, etc..., tous moyens qui compliquent sensiblement l'installation.

Par ailleurs, lorsqu'on applique ces techniques aux structures non résonnantes qui nécessitent que les deux faces soient traitées antireflet, on se heurte à de nouvelles difficultés. En effet, en optimisant, une face après l'autre, l'épaisseur de la couche déposée, on crée une dissymétrie d'épaisseur entre les deux couches finalement déposées. Cela vient de ce que, pendant le traitement antireflet de la première face, l'augmentation des pertes optiques induit un glissement spectral du gain optique de la structure, glissement qui va conduire à une épaisseur optimale légèrement différente pour la seconde face. Par ailleurs, lors du traitement de cette seconde face, un dépôt parasite viendra s'ajouter à la première face déjà traitée, qui désaccordera le premier traitement.

La présente invention a justement pour but de remédier à tous ces inconvénients.

A cette fin, elle propose un procédé de dépôt de couches antireflet et de contrôle de leur épaisseur qui est caractérisé par le fait que :
- on effectue le dépôt alternativement sur chacune des deux faces de l'amplificateur, par dépôts élémentaires successifs de faible épaisseur, les deux faces étant ainsi traitées en même temps, de manière symétrique,
- on mesure la tension aux bornes de l'amplificateur optique, tension dont on détecte le passage par un maximum, lequel indique qu'un minimum global de réflectivité pour l'ensemble des deux couches a été obtenu et l'on arrête alors le dépôt.

Le fait d'opérer alternativement sur, les deux faces, par petites quantités de matériau déposé, permet d'éviter l'inconvénient relatif à la dissymétrie des traitements.

L'utilisation de la tension électrique (au lieu de l'intensité lumineuse émise) comme moyen de détection de l'épaisseur optimale, permet d'éviter les inconvénients soulignés plus haut des systèmes optiques.

Par "bornes" de l'amplificateur auxquelles on mesure la tension, on entend les deux contacts électriques pris, d'une part, sur le substrat, et, d'autre part, sur le sommet de la structure. Les faces sur lesquelles le dépôt antireflet est effectué sont, en général, des faces clivées. Le courant injecté circule donc sensiblement perpendiculairement au plan des couches semi-conductrices et sensiblement parallèlement aux dépôts antireflet.

La corrélation entre une grandeur optique (la réflectivité d'une couche antireflet) et une grandeur électrique (la tension aux bornes de la structure semi-conductrice) sur laquelle s'appuye l'invention est surprenante. Elle peut s'expliquer de la manière suivante, selon les inventeurs.

Dans une structure laser à semi-conducteur, pour un courant d'injection donné, le nombre de porteurs dans la zone active est inversement proportionnel au nombre de photons présents dans la structure. La densité de porteurs (c'est-à-dire le nombre de porteurs par unité de volume) détermine l'écartement des quasi-niveaux de Fermi et, par conséquent, la tension aux bornes de la structure.

Par ailleurs, l'intensité lumineuse à l'intérieur de la structure résulte d'un équilibre entre l'amplification par émission stimulée et les pertes optiques de la cavité. Pour un courant d'injection constant, une augmentation des pertes liées à la diminution de la réflectivité d'une des faces entraîne une diminution de l'intensité lumineuse à l'intérieur de la cavité. Cette diminution réduit l'émission stimulée, ce qui a pour effet d'augmenter la densité de porteurs et donc de faire croître la tension aux bornes du laser.

Rechercher les meilleures couches antireflet revient donc bien à détecter un maximum de tension aux bornes de la structure semi-conductrice.

On observera en outre, qu'avec les procédés antérieurs nécessitant un photorécepteur aligné avec la face en cours de traitement, il eût été impossible de présenter alternativement les deux faces à traiter à l'évaporateur. Le recours à la mesure de la tension permet au contraire cette alternance.

La présente invention a également pour objet une installation de dépôt de couches antireflet qui met en oeuvre le procédé qui vient d'être défini.

De toute façon, les caractéristiques de l'invention apparaîtront mieux à la lumière de la description qui suit. Cette description porte sur des exemples de réalisation donnés à titre explicatif et nullement limitatif et elle se réfère à des dessins annexés, sur lesquels :
- la figure 1 illutre une installation conforme à l'invention,
- la figure 2 montre une courbe relevée avec une telle installation.

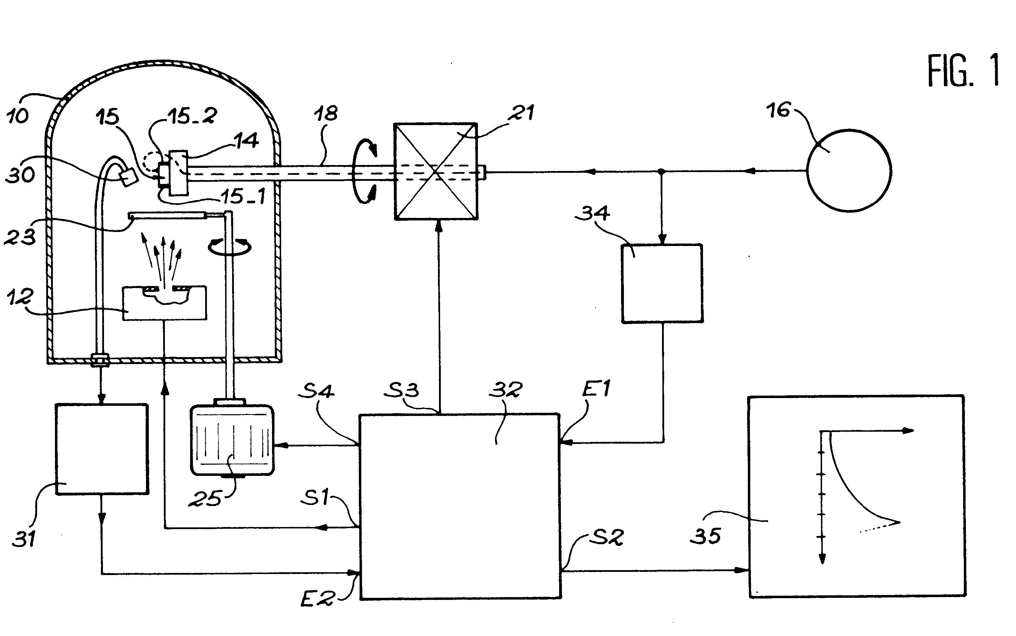

L'installation représentée sur la figure 1 comprend une enceinte de dépôt 10 équipée d'un moyen d'évaporation 12, d'un porte-échantillon 14 apte à recevoir l'amplificateur optique 15 dont les faces latérales 15-1 et 15-2 sont à traiter ; une source de courant constant 16 est reliée au porte-échantillon 14 et alimente en courant l'amplificateur optique 15 pendant le dépôt. Cette installation comprend en outre :
- des moyens 21 pour faire pivoter, demi-tour par demi-tour, le porte-échantillon 14, pour que soient présentées alternativement chacune des deux faces latérales 15-1, 15-2 de l'amplificateur au moyen d'évaporation 12,
- un voltmètre 34 mesurant la tension V aux bornes de l'amplificateur optique 15 (ou, ce qui revient au même, à la sortie de la source de courant 16),
- un cache escamotable 23 disposé dans l'enceinte 10, entre le moyen d'évaporation 12 et le porte-échantillon 14, et un moteur 25 apte à commander la position de ce cache,
- des moyens pour mesurer l'épaisseur e du dépôt effectué et comprenant un support de quartz 30 et une balance à quartz 31,
- des moyens 32 aptes à détecter l'instant où cette tension V passe par un maximum et à commander l'arrêt du moyen d'évaporation.

Sur la variante illustrée, ces derniers moyens 32 sont constitués par un calculateur ayant une première entrée E1 reliée au voltmètre 34 et recevant de celui-ci la tension V et une seconde entrée E2 reliée aux moyens 30, 31 aptes à mesurer l'épaisseur e du dépôt effectué.

Le calculateur 32 détermine la variation de tension dV, la variation d'épaisseur de, le rapport dV/de, et l'instant où ce rapport devient nul. Il possède par ailleurs une première sortie S1 délivrant un signal d'arrêt appliqué au moyen d'évaporation 12 lorsque le rapport calculé dV/de devient nul, une deuxième sortie S2 délivrant les quantités dV et e, une troisième sortie S3 commandant les moyens 21 aptes à faire pivoter d'un demi-tour le porte-échantillon 14, et enfin une quatrième sortie S4 pour commander le moteur 25 et interposer le cache 23, entre l'évaporateur et le porte-échantillon pendant que le support 14 pivote d'un demi-tour.

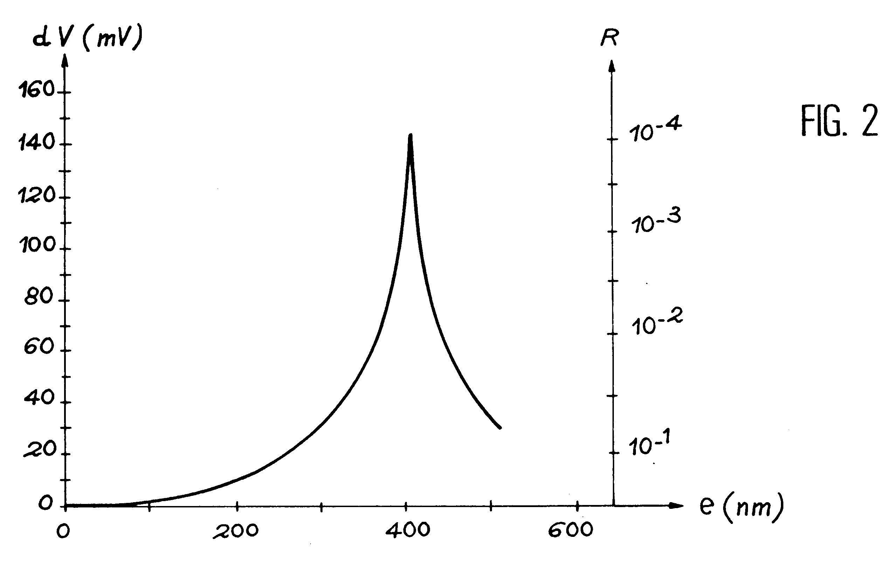

Un enregistreur 35 est relié à la deuxième sortie S2 du calculateur 32 et enregistre les variations de dV en fonction de l'épaisseur e. La figure 2 montre un exemple de courbe représentative de ces variations.

La courbe représentée correspond à une structure semi-conductrice qui avait 300 µm de long et qui était alimentée par un courant constant égal à 9 fois le seuil. Les couches élémentaires déposées alternativement sur les deux faces avaient, à chaque fois, une épaisseur de 10nm. En ordonnées, à gauche, est portée la variation de tension dV exprimée en millivolt et à droite, la réflectivité de l'ensemble. En abscisses, est portée l'épaisseur exprimée en nanomètre. L'optimum du traitement antireflet est obtenu pour une épaisseur de 400nm, ce qui correspond à 40 dépôts "élémentaires" de 10nm chacun. La réflectivité obtenue finalement est de 10⁻⁴ sur chacune des deux faces.

## Revendications

1. Procédé de dépôt de couches antireflet sur les faces d'un amplificateur optique non résonnant (15) et de contrôle de l'épaisseur de ces couches, procédé dans lequel on alimente, pendant le dépôt, l'amplificateur optique en courant constant (16) et on mesure la modification de l'une de ses caractéristiques en cours de dépôt pour déterminer l'instant où l'épaisseur des couches est optimale, ce procédé étant caractérisé par le fait que :
- on effectue le dépôt alternativement sur chacune des deux faces (15-1, 15-2) de l'amplificateur (15), par dépôts élémentaires successifs de faible épaisseur, les deux faces (15-1, 15-2) étant ainsi traitées en même temps de manière symétrique,
- la caractéristique dont on mesure la modification en cours de dépôt est la tension aux bornes de l'amplificateur optique, tension dont on détecte le passage par un maximum, lequel indique qu'un minimum global de réflectivité pour l'ensemble des deux couches a été obtenu et l'on arrête alors le dépôt.

2. Installation de dépôt de couches antireflet sur les deux faces (15-1, 15-2) d'un amplificateur optique non résonnant (15) et de contrôle de l'épaisseur de ces couches, pour la mise en oeuvre du procédé selon la revendication 1, cette installation comprenant une enceinte de dépôt (10) équipée d'un moyen d'évaporation (12) et d'un porte-échantillon (14) pour recevoir l'amplificateur optique (15), une source de courant constant (16) reliée au porte-échantillon (14) et apte à alimenter en courant l'amplificateur optique (15) pendant le dépôt, cette installation étant caractérisée par le fait qu'elle comprend en outre :
- des moyens (21) pour faire pivoter d'un demi-tour le porte-échantillon (14) pour que soient présentées alternativement chacune des deux faces (15-1, 15-2) de l'amplificateur au moyen d'évaporation (12),
- un voltmètre (34) mesurant la tension aux bornes de l'amplificateur optique (15),
- des moyens (32) aptes à détecter l'instant où cette tension passe par un maximum et à commander l'arrêt des moyens d'évaporation (12).

3. Installation selon la revendication 2, caractérisée par le fait qu'elle comprend en outre des moyens (30, 31) pour mesurer à chaque instant l'épaisseur du dépôt effectué.

4. Installation selon la revendication 3, caractérisée par le fait que les moyens aptes à détecter l'instant où la tension passe par un maximum et à commander l'arrêt du dépôt comprennent un calculateur (32) ayant une première entrée (E1) reliée au voltmètre (34) et recevant de celui-ci la tension mesurée, une seconde entrée (E2) reliée aux moyens (30, 31) pour mesurer l'épaisseur du dépôt effectué, ce calculateur calculant la variation de tension, la variation d'épaisseur, ainsi que le rapport de ces variations et déterminant l'instant où ce rapport devient nul, ce calculateur ayant une première sortie (S1) délivrant un signal d'arrêt appliqué au moyen d'évaporation (12) lorsque le rapport calculé devient nul.

5. Installation selon la revendication 5, caractérisée par le fait que le calculateur (32) comprend en outre une deuxième sortie (S2) délivrant les quantités: variation de tension et épaisseur de dépôt.

6. Installation, selon la revendication 1, caractérisée par le fait qu'elle comprend en outre un cache escamotable (23) disposé dans l'enceinte (10) entre le moyen d'évaporation (12) et le porte-échantillon (14) et un moteur (25) de commande de ce cache.

7. Installation selon la revendication 4, caractérisé par le fait que le calculateur (32) comprend en outre une troisième sortie (S3) commandant les moyens (21) pour faire pivoter d'un demi-tour le porte-échantillon (14), une quatrième sortie (S4) pour commander le moteur (25) agissant sur le cache escamotable (23) pendant que le porte-échantillon (14) pivote d'un demi-tour.

8. Installation selon la revendication 5, caractérisée par le fait qu'elle comprend en outre un enregistreur (34) relié à la deuxième sortie (S2) du calculateur (32) et enregistrant les variations de tension en fonction de l'épaisseur de dépôt mesurée par les moyens (30, 31).

## Patentansprüche

1. Verfahren zum Abscheiden von Antireflektionsschichten auf den Flächen eines nichtresonanten optischen Verstärkers (15) und zur Kontrolle der Dicke dieser Schichten, bei dem man während des Aufbringens den optischen Verstärker mit konstantem Strom (16) versorgt und man die Veränderung von einer seiner Charakteristika im Laufe des Abscheidens mißt, um den Zeitpunkt zu ermitteln, wo die Dicke der Schichten optimal ist, wobei dieses Verfahren **dadurch gekennzeichnet** ist:
- daß man die Abscheidung abwechselnd auf jeder der beiden Flächen (15-1, 15-2) des Verstärkers (15) durchführt, mittels Elementarabscheidungen von geringer Dicke, wobei die beiden Flächen (15-1, 15-2) somit gleichzeitig auf symetrische Weise behandelt werden,
- daß die Charakteristik, deren Veränderung man im Laufe der Abscheidung mißt, die Spannung an den Klemmen des optischen Verstärkers ist, deren Durchgang durch ein Maximum man feststellt, das anzeigt, daß ein Gesamtminimum an Reflektivität für die Gesamtheit der beiden Schichten erreicht wurde, woraufhin man die Abscheidung beendet.

2. Anlage zur Abscheidung von Antireflektionschichten auf den beiden Flächen (15-1, 15-2) eines nichtresonanten optischen Verstärkers (15) und zur Kontrolle der Dicke dieser Schichten für die Anwendung des Verfahrens nach Anspruch 1, wobei diese Anlage einen Abscheidebehälter (10) umfaßt, ausgestattet mit einer Verdampfungseinrichtung (12) und einem Musterhalter (14) für die Aufnahme des optischen Verstärkers (15), eine Konstantstromquelle (16), verbunden mit dem Musterhalter (14) und fähig, den optischen Verstärker (15) während der Abscheidung mit Strom zu versorgen, wobei diese Anlage **dadurch gekennzeichnet** ist, daß sie außerdem umfaßt:
- Einrichtungen (21) zum Drehen des Musterhalters (14) um eine Halbdrehung, damit wechselweise jede der beiden Flächen (15-1, 15-2) des Verstärkers der Verdampfungseinrichtung (12) präsentiert wird,
- ein Voltmeter (34), das die Spannung an den Klemmen des optischen Verstärkers (15) mißt,
- Einrichtungen (32), um den Zeitpunkt zu ermitteln, wo diese Spannung ein Maximum durchläuft, und um die Verdampfungseinrichtungen (12) abzuschalten.

3. Anlage nach Anspruch 2, dadurch gekennzeichnet, daß sie außerdem Einrichtungen (30, 31) umfaßt, um zu jedem Zeitpunkt die Dicke der erzeugten Abscheidung zu messen.

4. Anlage nach Anspruch 3, dadurch gekennzeichnet, daß die Einrichtungen zum Ermitteln des Zeitpunkts, wo die Spannung ein Maximum durchläuft, und zum Abschalten der Verdampfungseinrichtung einen Rechner (32) umfassen, mit einem ersten Eingang (E1), verbunden mit dem Voltmeter (34) und von diesem die gemessene Spannung erhaltend, einem zweiten Eingang (E2), verbunden mit den Einrichtungen zum Messen der Dicke der erzeugten Abscheidung, wobei dieser Rechner die Spannungsänderung, die Dickenänderung sowie das Verhältnis dieser Änderungen berechnet und den Zeitpunkt ermittelt, wo dieses Verhältnis Null wird, und dieser Rechner einen ersten Ausgang (S1) hat, der ein Halt-Signal liefert für die Verdampfungseinrichtungen (12), wenn das berechnete Verhältnis Null wird.

5. Anlage nach Anspruch 4, dadurch gekennzeichnet, daß der Rechner (32) außerdem einen zweiten Ausgang (S2) umfaßt, der die Größen Spannungsänderung und Abscheidungsdicke liefert.

6. Anlage nach Anspruch 1, dadurch gekennzeichnet, daß sie außerdem eine schwenkbare Maske (cache) (23) umfaßt, in dem Behälter (10) angeordnet zwischen den Verdampfungseinrichtungen (12) und dem Musterhalter (14), und einen Antriebsmotor (25) für diese Maske.

7. Anlage nach Anspruch 4, dadurch gekennzeichnet, daß der Rechner (32) außerdem einen dritten Ausgang (S3) umfaßt, der die Einrichtungen (21) steuert, um den Musterhalter (14) eine Halbdrehung ausführen zu lassen, einen vierten Ausgang (S4), um den Motor (25) zu steuern, der auf die schwenkbare Maske (23) wirkt, während der Musterhalter (14) um eine Halbdrehung schwenkt.

8. Anlage nach Anspruch 5, dadurch gekennzeichnet, daß sie außerdem ein Aufzeichnungsgerät (34) umfaßt, verbunden mit dem zweiten Ausgang (S2) des Rechners (32), das die Spannungsänderungen aufzeichnet in Abhängigkeit von der durch die Einrichtungen (30, 31) gemessenen Abscheidungsdicke.

## Claims

1. Process for the deposition of anti-reflection coatings on the faces of a non-resonating optical amplifier (15) and for checking the thickness of said coatings, in which during deposition the optical amplifier is supplied with a constant current (16) and the modification of one of its characteristics is measured during deposition to determine the time when the thickness of the coatings is at an optimum, characterized in that deposition alternately takes place on each of the two faces (15-1, 15-2) of the amplifier (15), using successive elementary deposits of limited thickness, so that the two faces (15-1, 15-2) are in this way treated simultaneously and symmetrically and the characteristics whose modification is measured during deposition is the voltage at the terminals of the optical amplifier and the passage through a maximum of said voltage is detected and this indicates that an overall minimum reflectivity has been obtained for the two coatings and deposition is then stopped.

2. Installation for the deposition of anti-reflection coatings on the two faces (15-1, 15-2) of a non-resonating optical amplifier (15) and for checking the thickness of these two coatings, for performing the process according to claim 1, said installation comprising a deposition enclosure (10) equipped with a sputtering means (12) and a sample holder (14) for receiving the optical amplifier (15), a constant current source (16) connected to the sample holder (14) and able to supply the optical amplifier (15) with current during deposition, said installation being characterized in that it also has means (21) for pivoting the sample holder (14) by a half-turn, so that each of the two faces (15-1, 15-2) of the amplifier is alternately presented to the sputtering means (12), a voltmeter (34) measuring the voltage at the terminals of the optical amplifier (15) and means (32) able to detect the time when said voltage passes through a maximum and for controlling the stopping of the sputtering means (12).

3. Installation according to claim 2, characterized in that it also has means (30, 31) for at all times measuring the thickness of the deposit made.

4. Installation according to claim 3, characterized in that the means able to detect the time when the voltage passes through a maximum and control the stopping of deposition comprise a computer (32) having a first input (E1) connected to the voltmeter (34) and receiving from the latter the measured voltage, a second input (E2) connected to the means (30, 31) for measuring the thickness of the deposit made, said computer calculating the voltage variation, the thickness variation and the ratio of these variations and determining the time when said ratio becomes zero, said computer having a first output (S1) supplying a stop signal applied to the sputtering means (12) when the calculated ratio becomes zero.

5. Installation according to claim 5, characterized in that the computer (32) also has a second output (S2) supplying the quantities: voltage variation and deposit thickness.

6. Installation according to claim 1, characterized in that it also has a retractable mask (23) located in the enclosure (10) between the sputtering means (12) and the sample holder (14) and a motor (25) for controlling said mask.

7. Installation according to claim 4, characterized in that the computer (32) also has a third output (S3) controlling the means (21) for pivoting the sample holder (14) by a half-turn, a fourth output (S4) for controlling the motor (25) acting on the retractable mask (23) during the pivoting by a half-turn of the sample holder (14).

8. Installation according to claim 5, characterized in that it also has a recorder (34) connected to the second output (S2) of the computer (32) and recording the voltage variations as a function of the deposit thickness measured by the means (30, 31).
